**Europäisches Patentamt**

**European Patent Office**

**Office européen des brevets**

(19)

(11)    **EP 1 202 068 A2**

(12)    **EUROPÄISCHE PATENTANMELDUNG**

(43)    Veröffentlichungstag:
        **02.05.2002   Patentblatt 2002/18**

(51)  Int Cl.7: **G01R 27/26**

(21)    Anmeldenummer: **01125621.1**

(22)    Anmeldetag: **26.10.2001**

(84)    Benannte Vertragsstaaten:
        **AT BE CH CY DE DK ES FI FR GB GR IE IT LI LU
        MC NL PT SE TR**
        Benannte Erstreckungsstaaten:
        **AL LT LV MK RO SI**

(30)    Priorität: **27.10.2000   DE 10053279**

(71)    Anmelder:
        • **Philips Corporate Intellectual Property GmbH
          52064 Aachen (DE)**
          Benannte Vertragsstaaten:
          **DE**
        • **Koninklijke Philips Electronics N.V.
          5621 BA Eindhoven (NL)**
          Benannte Vertragsstaaten:
          **ES FR GB**

(72)    Erfinder:
        • **Loef, Christoph, Philips Corp. Intel. Prop. GmbH
          52064 Aachen (DE)**
        • **Hattrup, Christian,
          Philips Corp. Inte. Prop. GmbH
          52064 Aachen (DE)**
        • **Gercke, Thorsten,
          Philips Corp. Intel. Prop. GmbH
          52064 Aachen (DE)**

(74)    Vertreter: **Volmer, Georg, Dipl.-Ing. et al
        Philips Corporate Intellectual Property GmbH,
        Habsburgerallee 11
        52064 Aachen (DE)**

(54)    **Verfahren zur Bestimmung der Ausgangskapazität einer
        Spannungsversorgungsvorrichtung**

(57)    Die Erfindung betrifft ein Verfahren zur Bestimmung der Ausgangskapazität einer Spannungsversorgungsvorrichtung sowie eine Spannungsversorgungsvorrichtung und ein Röntgengerät. Zur besonders einfachen Bestimmung der Ausgangskapazität einer Spannungsversorgungsvorrichtung wird ein Messverfahren vorgeschlagen, bei dem eine Ausgangsspannung in Höhe eines vorgegebenen ersten Messspannungswerts erzeugt wird, und danach die Spannungsversorgung abgeschaltet wird, so dass sich die Ausgangskapazität über mindestens einen in der Spannungsversorgungseinrichtung vorgesehenen Messwiderstand entlädt, wobei aus der Entladekurve die Ausgangskapazität ermittelt wird.

**EP 1 202 068 A2**

**Beschreibung**

Die Erfindung betrifft ein Verfahren zur Bestimmung der Ausgangskapazität einer Spannungsversorgungsvorrichtung sowie eine Spannungsversorgungsvorrichtung und ein Röntgengerät mit einer Spannungsversorgungsvorrichtung.

Spannungsversorgungsvorrichtungen dienen zur Versorgung von Verbrauchern mit elektrischer Energie, wobei eine Spannungsversorgungsvorrichtung üblicherweise mindestens zwei Ausgangsanschlüsse aufweist und zwischen diesen Ausgangsanschlüssen eine definierte, geregelte oder ungeregelte Versorgungsspannung für den angeschlossenen Verbraucher liefert.

Insbesondere Hochspannungsversorgungsvorrichtungen werden häufig als Schaltnetzteile ausgeführt. Sie entnehmen dem Spannungsversorgungsnetz elektrische Energie und setzen sie in die zum Betrieb des Verbrauchers erforderlichen Spannungswerte um. Beispielsweise muss eine Hochspannungversorgung für eine Röntgenröhre Spannungen im Bereich von ca. 40 kV bis 150 kV und Ströme bis 1,3 A liefern, wobei die Röhrenspannung mit einem Regler auf den erforderlichen Sollwert geregelt wird.

Insbesondere bei Spannungsversorgungsvorrichtungen, bei denen die Ausgangsspannung durch einen Regler geregelt wird, ist ein wichtiger Parameter die ausgangsseitige Kapazität der Spannungsversorgungsvorrichtung. Eine besondere Rolle spielt dieser Parameter, wenn eine Hochspannungsversorgungsvorrichtung als Resonanzkreis ausgelegt ist. Für eine optimale Regelung der Ausgangsspannung muss dieser Parameter berücksichtigt werden.

Hierbei ist der Wert der ausgangsseitigen Kapazität stark von der Beschaltung der Spannungsversorgungsvorrichtung abhängig. Insbesondere Kabelkapazitäten spielen hier eine Rolle.

Bei Hochspannungsversorgungen für Röntgenröhren wurde dies in der Vergangenheit berücksichtigt, indem nach einer empirischen Formel ausgehend von der Kabellänge ein Schätzwert für die ausgangsseitige Kapazität festgelegt und in der Regelung berücksichtigt wurde. Dieses Verfahren ist jedoch für das Bedienpersonal aufwendig und im Ergebnis auch recht ungenau.

Es ist daher Aufgabe der Erfindung, die bekannten Verfahren und Vorrichtungen, insbesondere auch Röntgengeräte, so zu verbessern, dass die Bestimmung der Ausgangskapazität auf einfache Weise möglich ist.

Diese Aufgabe wird gelöst durch ein Verfahren nach Anspruch 1, eine Spannungsversorgungsvorrichtung nach Anspruch 9 und ein Röntgengerät nach Anspruch 12. Abhängige Ansprüche beziehen sich auf vorteilhafte Ausführungsformen.

Erfindungsgemäß wird die Ausgangskapazität der Spannungsversorgungsvorrichtung ermittelt, indem eine ausgangsseitige Entladekurve erzeugt und aus deren Verlauf der Wert der Ausgangskapazität ermittelt wird.

Die hat den Vorteil, dass - im Gegensatz zur Schätzung der Kapazität anhand der Kabellänge - sämtliche parasitären Kapazitäten durch die Messung berücksichtigt werden und so ein recht genauer Wert ermittelt wird.

Eine Entladekurve wird erfindungsgemäß erzeugt, indem die Spannungsversorgung zunächst eine Ausgangsspannung erzeugt, auf die die Ausgangskapazität aufgeladen wird, und diese dann über das RC-Glied aus Ausgangskapazität und einem Messwiderstand entladen wird. Im einfachsten Fall wird die zunächst erzeugte Spannung (erster Messspannungswert) hierfür abgeschaltet; eine Entladekurve ergibt sich aber selbstverständlich auch dann, wenn die Spannung lediglich auf einen geringeren Wert heruntergeschaltet wird.

Es soll hier darauf geachtet werden, dass das Timing der Messung so gewählt wird, dass stets nur eingeschwungene Zustände berücksichtigt werden, so dass keine Transienten die Messung beeinflussen.
Die Ermittlung der Ausgangskapazität aus dem Verlauf der Entladekurve geschieht bevorzugt über die Aufnahme von Messwerten der Spannung zwischen den Ausgangsanschlüssen zu verschiedenen Zeitpunkten. Im einfachsten Fall sind hier nur zwei Messwerte erforderlich. Einer dieser Messwerte kann zwar prinzipiell der erste Messspannungswert sein (auf den die Ausgangskapazität zu Beginn der Messung aufgeladen wird). Um eine bessere Genauigkeit zu erzielen wird aber bevorzugt, die erste Messung erst nach Ablauf einer Wartezeit nach Ausschalten der Spannungsversorgung durchzuführen.

Aufgrund des rechnerisch bekannten Verlaufs der resistiven Entladung eines Kondensators $U(t) = U_{Anfang} e^{-t/RC}$ ist aus zwei Spannungsmessungen zu bekannten Zeitpunkten der Kapazitätswert bereits eindeutig zu bestimmen. Hierfür muss allerdings der Wert des Messwiderstands möglichst genau bekannt sein.

Gemäß einer Weiterbildung der Erfindung wird die Messung anhand von zwei vorgegebenen Spannungswerten, einem Startspannungswert und einem Endspannungswert durchgeführt. Durch kontinuierliche Messung der Ausgangsspannung wird zunächst festgestellt, wann die Ausgangsspannung auf den Startspannungswert abgefallen ist. Dann wird weiter gemessen, bis der Endspannungswert erreicht ist. Bei bekanntem Messwiderstand R und festen Start- und Endspannungswerten $U_A$ und $U_B$ kann auf sehr einfache Weise die Kapazität C berechnet werden. Diese ist nämlich der Zeitdifferenz proportional.

Alternativ hierzu können auch zwei Zeitpunkte (bevorzugt nach Ablauf einer Wartezeit) festgelegt sein, wobei die Spannung zu diesen festen Zeitpunkten gemessen wird und daraus die Kapazität anhand des rechnerisch bekannten Verlaufs berechnet wird. Dies ist aber wegen der erforderlichen Logarithmus-Berechnung numerisch aufwendig.

Wie bereits erwähnt beeinflusst die genaue Kenntnis des Werts des Messwiderstands auch die Genauigkeit der Kapazitätsmessung. Bei Hochspannungsversorgungsvorrichtungen, insbesondere für Röntgenröhren, sind ausgangsseitig stets hochgenaue Widerstände (Abweichung unterhalb 1 %) als Spannungsteiler vorgesehen. Denn von der durch die Spannungsversorgungsvorrichtung erzeugten Hochspannung wird üblicherweise nur ein heruntergeteilter Anteil gemessen. Besonders vorteilhaft ist es nun, dass sowohl die in vielen Hochspannungsversorgungsvorrichtungen vorgesehenen Spannungsteiler als auch die ebenfalls bereits vorgesehenen Spannungsmesseinrichtungen zur Ermittlung der Ausgangskapazität genutzt werden. Somit ist keinerlei externe Beschaltung bzw. Anbringen von Messgeräten erforderlich. Vielmehr kann die Messung durch das Gerät vollständig automatisch geschehen, wobei eine Steuervorrichtung die Spannungsversorgungsvorrichtung entsprechend steuert. Bei einer solchen Steuervorrichtung kann es sich um ein beliebiges dem Fachmann bekanntes Mittel handeln, beispielsweise eine Mikroprozessor-Steuerung.

Spannungsversorgungsvorrichtungen umfassen üblicherweise Anschlussvorrichtungen für einen Verbraucher, insbesondere Stecker und Kabel. Besonders vorteilhaft ist die Durchführung des erfindungsgemäßen Messverfahrens bei angeschlossenen Anschlussvorrichtungen. Denn insbesondere angeschlossene Kabel beeinflussen durch ihre Kabelkapazität den gesuchten Wert der Ausgangskapazität maßgeblich.

Besonders günstig ist es, wenn die Spannung sogar bei angeschlossenem Verbraucher durchgeführt werden kann. Hierbei muss allerdings eine Verfälschung der Messung durch den Verbraucher entweder ausgeschlossen oder herausgerechnet werden. Wenn es sich bei dem Verbraucher um eine Röntgenröhre handelt, kann dies erreicht werden, indem der Heizfaden der Röhre stromlos ist, so dass kein Strom in der Röhre fließen kann. In der Praxis ist hierbei allerdings zu beachten, dass es - auch ohne Kathodenheizung - bei hohen Spannungswerten zu Elektrodenemission (Kaltemission) kommen kann. Der Fachmann wird hierbei darauf achten, dass die Messung bei Spannungen durchgeführt wird, bei denen keine störende Kaltemission stattfindet.

Ein erfindungsgemäßes Röntgengerät umfasst mindestens eine Röntgenröhre sowie eine Spannungsversorgungsvorrichtung mit einer Vorrichtung zur automatischen Bestimmung der Ausgangskapazität. Besonders bei einem Röntgengerät ist die exakte Ermittlung der Ausgangskapazität für die notwendige hochgenaue Regelung der Ausgangsspannung von großer Bedeutung.

Dies ist insbesondere der Fall bei einer Anordnung, bei der eine zentrale Spannungsversorgungsvorrichtung mehrere Röntgenröhren durch Kabel versorgt. Hier unterscheiden sich - je nach Kabellänge, Anordnung etc. - die Ausgangskapazitäten je nachdem, welche Röntgenröhre aktuell angesteuert wird. Beispielsweise nach jeder Umschaltung oder auch vor jedem Einschalten der Röntgenröhre kann eine automatische Messung der Ausgangskapazität durchgeführt werden, so dass der Regler für die Spannungsversorgung den korrekten Wert der Ausgangskapazität als Parameter erhält.

Nachfolgend wird eine Ausführungsform der Erfindung anhand von Zeichnungen näher beschrieben. In den Zeichnungen zeigen:

Fig. 1     ein Schaltbild einer Hochspannungs-Versorgung für eine Röntgenröhre;

Fig. 2     ein Diagramm der Entladekurve der Ausgangskapazität über einen Messwiderstand.

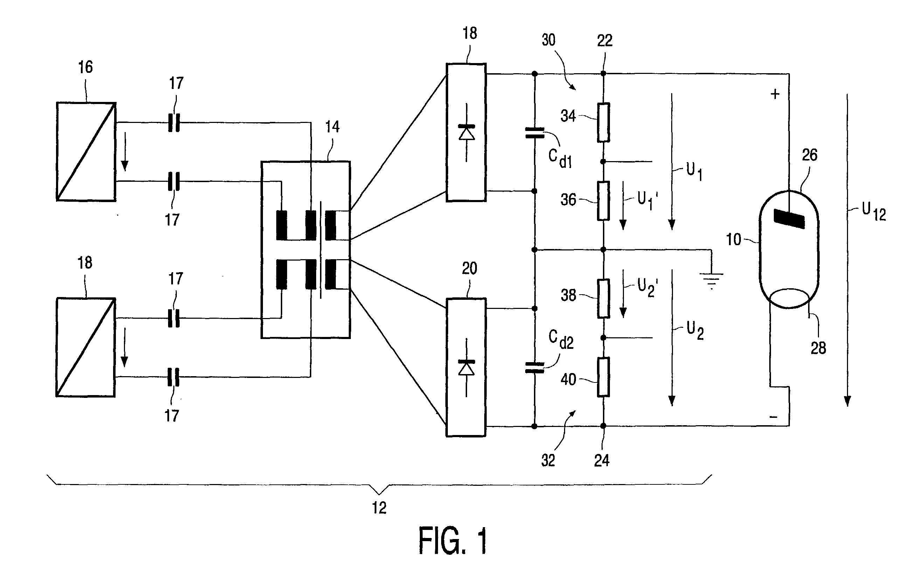

In Fig. 1 ist eine Schaltung für ein Röntgengerät mit einer Röntgenröhre 10 und einer Spannungsversorgungsschaltung 12 dargestellt. Die Spannungsversorgungsschaltung 12 ist als lastresonanter Umrichter aufgebaut. Sie umfasst einen Transformator 14, an den primärseitig die beiden Umrichter 16, 18 angeschlossen sind. Sekundärseitig sind an den Transformator 14 die Gleichrichterbrücken 18, 20 angeschlossen, deren Ausgangsanschlüsse 22, 24 einerseits mit der Anode 26 bzw. der Kathode 28 der Röntgenröhre 10 und andererseits mit Masse verbunden sind.

Die Erzeugung der Hochspannung $U_{12}$ zwischen den Ausgangsanschlüssen 22, 24 geschieht folgendermaßen: Die Umrichter 16, 18 laufen synchronisiert und liefern, gespeist durch die Netzspannung (nicht dargestellt), die Spannungen $U_1$ bzw. $U_2$ an der Primärseite des Transformators 14. Im Transformator 14 wird die niedrigere Eingangsspannung in eine Hochspannung transformiert. Hierbei weist die Sekundärseite des Hochspannungstransformators 14 vier Abgriffe auf, wobei jede der Gleichrichterbrücken 18, 20 jeweils an zwei Abgriffen angeschlossen ist. Die sekundärseitige Ausgangs-Wechselspannung (Hochspannung) des Transformators 14 wird durch die Gleichrichterbrücken 18, 20 gleichgerichtet. Deren Ausgangsspannungen $U_1$, $U_2$ sind symmetrisch zum Erdpotential, d.h. die Anodenspannung $U_1$ weist den gleichen Spannungsbetrag gegenüber dem Erdpotential auf wie die Kathodenspannung $U_2$.

Zwischen die Ausgangsanschlüsse 22, 24 und das Erdpotential sind die Spannungsteiler 30, 32 aus den Messwiderständen 34, 36, 38, 40 geschaltet. Die Spannungsteiler 30, 32 dienen jeweils zur Herabteilung der Anodenspannung $U_1$ bzw. der Kathodenspannung $U_2$ auf die deutlich niedrigeren Spannungen $U_1'$ und $U_2'$. Die Widerstände erfüllen hohe Genauigkeitsanforderungen; sie haben eine Abweichung von weniger als 1%.

Zwischen den Ausgangsanschlüssen 22, 24 und dem Erdpotential sind auch die Ausgangskapazitäten $C_{d1}$ und $C_{d2}$ im Schaltplan eingezeichnet. In der Praxis handelt es sich hierbei nicht um diskrete Bauelemente. Sondern diese Kapazitäten treten als parasitäre Kapazitäten, vor allem als Kabelkapazitäten des Anschlusskabels auf, mit dem die Röntgenröhre 10 mit der Spannungsversorgungsschaltung 12 verbunden ist (nicht dargestellt). Die Kapazitäten $C_{d1}$ und $C_{d2}$ dienen in der Spannungsversorgungsschaltung 12 als Pufferkapazitäten für die Ausgangsspannungen $U_1$, $U_2$.

Wie bereits erwähnt arbeitet die Spannungsversorgungsschaltung 12 insgesamt als lastresonanter Umrichter. Der Primärkreis wird hierbei durch die Streuinduktivität des Transformators 14 und Resonanzkondensatoren 17 zu einem Serienresonanzkreis ergänzt. Die sekundärseitige Wicklungskapazität des Hochspannungstransformators 14 erweitert den Lastkreis zu einem serien-parallel-resonanten Resonanzkreis. Die Arbeitsfrequenz der synchronisierten Umrichter 16, 18 wird hierbei so gewählt, dass diese nahe der Eigenresonanzfrequenz des Lastkreises liegt. Dadurch wird der Spannungsabfall an der Impedanz des Resonanzkreises minimal.

Die Spannungsversorgungsschaltung 12 mit zwei Umrichtern 16, 18 und zwei Gleichrichterbrücken 18, 20, die symmetrisch zum Erdpotential sind, ist selbstverständlich nicht zwingend der einzig mögliche Aufbau einer solchen Schaltung. Je nach Anforderungen können auch beispielsweise nur ein Umrichter und/oder nur eine Gleichrichterbrücke vorgesehen sein. In diesem Fall ist von der Primär- und/oder die Sekundärseite der in Fig. 1 dargestellten Schaltung nur jeweils einer der identischen oberen bzw. unteren Teile der Schaltung vorhanden.

Im Betrieb des Röntgengeräts ist eine sehr schnelle und hochgenaue Steuerung der Hochspannung $U_{12}$ zwischen Anode 26 und Kathode 28 der Röntgenröhre 10 erforderlich. So ist bei Ansteuerung der Röntgenröhre zur Durchführung einer Röntgenaufnahme im medizinischen Bereich beispielsweise eine Anforderung, dass die Anstiegszeit (d.h. die Zeit zwischen dem Erreichen von 10% bis zum Erreichen von 90% der Nennspannung) weniger als eine Millisekunde betragen soll. Denn die Röntgenstrahlung die bei niedrigeren Spannungen erzeugt wird trägt nicht zur Bildqualität bei, sondern erhöht lediglich die Strahlenbelastung des Patienten.

Aus diesem Grund wird ein sehr schneller und hochgenauer Regler eingesetzt, der die Umrichter 16, 18 so steuert, dass ausgangsseitig die gewünschte Spannung $U_{12}$ erzeugt wird. Für diesen Regler bilden die gemessenen Spannungen $U_1'$ und $U_2'$, d.h. die heruntergeteilten Anteile der Anoden- bzw. Kathodenspannung, die Regelgröße. Ein wichtiger Parameter bei dieser Regelung ist die Größe der Kapazitäten $C_{d1}$ und $C_{d2}$.

Zur Bestimmung dieser Kapazitäten wird das im folgenden beschriebene automatisch Messverfahren angewendet, das die folgende Schritte umfasst:

- Ansteuerung der Spannungsversorgungsschaltung 12 so, dass eine Ausgangsspannung $U_{12}$ eines Messspannungswertes von beispielsweise 40 kV erzeugt wird.
- Abschalten des Umrichters, so dass keine weitere Spannungsversorgung erfolgt und sich die auf den Messspannungswert (40 kV) aufgeladenen Ausgangskapazitäten $C_{d1}$ und $C_{d2}$ über die Messwiderstände 34, 36, 38, 40 entladen.
- Beobachtung der Entladekurve durch Messung der Spannungen $U_1$ und $U_2$ (bzw. Messung der heruntergeteilten Spannungen $U_1'$ und $U_2'$) zu verschiedenen Zeitpunkten.
- Ermittlung der Kapazitätswerte $C_{d1}$ und $C_{d2}$ (aus den gemessenen Werten).

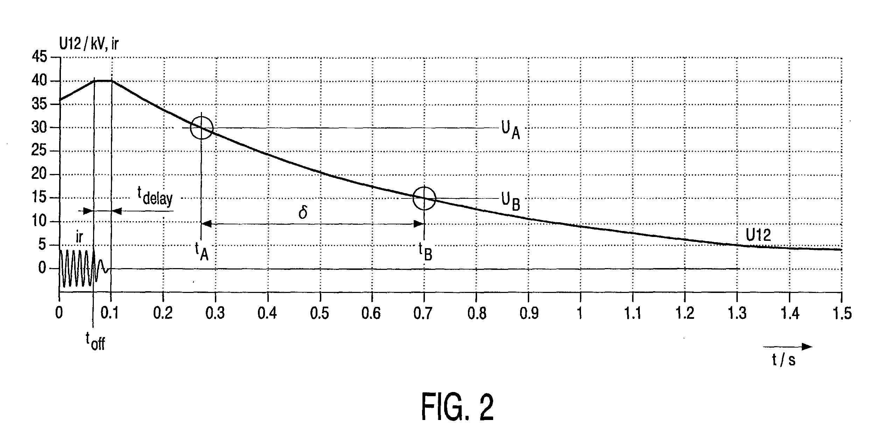

Der Ablauf des Messverfahrens wird nun im Hinblick auf die in Fig. 2 dargestellte Entladekurve detailliert erläutert.

Zunächst werden die Umrichter 16, 18 so angesteuert, dass ausgangsseitig eine Spannung $U_{12}$ von ca. 40 kV eingestellt wird. Die Genauigkeit, mit der dieser erste Messspannungswert erreicht wird, ist nicht kritisch. Denn die eigentliche Messung erfolgt erst im mittleren Bereich der Entladekurve. Nach dem Abschalten der weiteren Spannungsversorgung zum Zeitpunkt $t=t_{off}$ wird zunächst eine Zeitdauer $t_{delay}$ abgewartet, bis parasitäre Schwingungen auf der Primär- und Sekundärseite des Transformators 14 abgeklungen sind. Erst nach dieser Zeitdauer ist sichergestellt, dass dem Ausgangskreis keine weitere Energie zugeführt wird. Die Kapazitäten $C_{d1}$ und $C_{d2}$ sind nun auf die symmetrischen Spannungen $U_1$ und $U_2$ von jeweils $U_{12}/2$ = ca. 20 kV aufgeladen und entladen sich über die Widerstände 34, 36, 38, 40 der Spannungsteiler 30, 32.

Für den weiteren Verlauf der Messungen wird nun die Spannung $U_{12}$ fortlaufend gemessen, wobei ein Startspannungswert $U_A$ und ein Endspannungswert $U_B$ vorgegeben sind, die sich ausreichend voneinander unterscheiden und beide unterhalb des ersten Messspannungswerts von 40 kV liegen. Hierbei ist $U_A$ größer als $U_B$. Bevorzugt sind die Werte so gewählt, dass sie innerhalb der Bereiche von 10% bis 90% der maximalen Spannung der Entladekurve liegen. In der Praxis wird der Fachmann bei der Wahl von $U_A$ und $U_B$ berücksichtigen, dass die Messung von einer Steuerung mit einem Signalprozessor ausgewertet wird. Dieser muss in der Lage sein, die Messungen ausreichend schnell zu verarbeiten. Da aber der zeitliche Abstand zwischen den Messpunkten $U_A$ und $U_B$ von der Kapazität C abhängt (wobei der Abstand bei sehr geringem C nur sehr kurz ist), soll sichergestellt werden, dass für alle zu erwartenden Kapazitätswerte C die Messung noch ausgeführt und verarbeitet werden kann.

Bei der fortlaufenden Messung wird der Spannungswert $U_{12}$ über ein digitales Filter gleitend gemittelt, so dass Störungen ausgefiltert werden können und die Messung hierdurch nicht beeinflusst wird. In der Praxis hat sich eine Mittelung über 8 Messwerte bewährt. Bei der fortlaufenden Messung werden die Zeitpunkte $t_A$ und $t_B$ erfasst, zu denen die Spannung $U_{12}$ die vorgegebenen Start- bzw. Endspannungswerte $U_A$ und $U_B$ erreicht bzw. unterschreitet. Die Zeitdifferenz $\delta$ ergibt sich zu $\delta = t_B - t_A$.

Die Berechnung des Kapazitätswertes hieraus erfolgt unter Verwendung der allgemein bekannten Funktion, die die resistive Entladung eines Kondensators beschreibt:

$$U_B = U_A e^{\frac{-\delta}{\tau}} \quad\quad (1.0)$$

mit

$$\tau = R \cdot C \quad\quad (1.1).$$

Hieraus folgt

$$\Rightarrow \quad \frac{U_B}{U_A} = e^{\frac{-\delta}{\tau}} \quad (2.1) \quad \Rightarrow \quad In\left(\frac{U_B}{U_A}\right) = \frac{-\delta}{R \cdot C} \quad (2.2).$$

Dies lässt sich auflösen nach dem Kapazitätswert C zu

$$C = \frac{\delta}{In\left(\frac{U_A}{U_B}\right) \cdot R} \quad\quad (2.3).$$

Da die Größe des Entladewiderstands R bekannt ist und die Start- und Endspannungswerte UA, UB ebenfalls fest sind, entspricht der Nenner in (2.3) einer Konstanten

$$K = In\left(\frac{U_A}{U_B}\right) \cdot R \quad\quad (3.2),$$

so dass der Kapazitätswert C der Zeitdifferenz $\delta$ proportional ist

$$C = \frac{\delta}{K} \quad\quad (3.1).$$

Während durch das oben beschriebene Verfahren, das von der Entladekurve für $U_{12}$ ausgeht, die Summe der Kapazitäten $C_{d1}$ und $C_{d2}$ ermittelt wird, kann durch separate Messung der Spannungen $U_1$ und $U_2$ die Meßmethode einzeln für die anodenseitige Kapazität $C_{d1}$ und die kathodenseitige Kapazität $C_{d2}$ durchgeführt werden, so dass sich diese Kapazitätswerte und ihre Abweichung voneinander einzeln bestimmen lassen.

Das Röntgengerät, dessen Stromversorgungsschaltung 12 in Fig. 1 dargestellt ist, weist eine Steuervorrichtung (nicht dargestellt) auf, die diese Messung automatisch durchführt. Durch die Steuervorrichtung wird auch die Heizkathode der Röntgenröhre 10 angesteuert. Während der Durchführung einer Kapazitätsmessung ist die Kathode 28 der Röntgenröhre 10 ungeheizt, so dass keine Elektroden austreten und auch kein Strom in der Röhre 10 fließt. Somit wird die Messung bei angeschlossener Röhre durchgeführt und kann so sämtliche Anschluss- und Kabelkapazitäten berücksichtigen.

Die Steuervorrichtung des Röntgengeräts ist eine Mikroprozessor-Steuerung, die auch mit der (ebenfalls nicht dargestellten) Messeinrichtung für die Spannungen $U_1'$ und $U_2'$ gekoppelt ist. Da der Regler des Röntgengeräts digital auf dieser Mikroprozessor-Steuerung implementiert ist und als solcher ohnehin die Ansteuerung der Umrichter 16, 18 ausführt sowie die Spannungsmesswerte $U_1'$ und $U_2'$ auswertet, kann auf einfache Weise auch die Steuerung des automatischen Messverfahrens von der Mikroprozessor-Steuerung übernommen werden.

Ein hierauf ablaufendes Programm übernimmt die entsprechende Ansteuerung der Spannungsversorgungsschaltung 12 und die Auswertung der Spannungsmessungen $U_1'$ und $U_2'$ mit Ermittlung des Werts für die Zeitdifferenz $\delta$ wie oben beschrieben. Da für ein bestimmtes Gerät die Größe der Widerstände 34, 36, 38, 40 festgelegt und bekannt ist und da für jedes Gerät auch der Start- und Endspannungswert $U_A$, $U_B$ festgelegt ist, beschränkt sich die Berechnung des Kapazitätswerts C auf die Division $\delta/K$ bzw. (numerisch vorteilhafter) die Multiplikation mit dem Kehrwert von K.

In einer zweiten Ausführungsform (nicht dargestellt) versorgt eine Spannungsversorgungsschaltung 12 mehrere Röntgenröhren. Die Röntgenröhren sind hierbei jeweils über Kabel verschiedener Länge mit der Spannungsversorgungsschaltung 12 gekoppelt. Mit Hilfe eines Umschalters wird jeweils eine der Röntgenröhren ausgewählt und mit den Ausgangsanschlüssen 22, 24 verbunden.

Bei der zweiten Ausführungsform variiert der Wert für die Kapazitäten $C_{d1}$ und $C_{d2}$ je nach angeschlossener Röntgenröhre. Mindestens nach jeder Änderung der Konfiguration wird daher eine automatische Kapazitätsmessung durchgeführt.

**Patentansprüche**

1.  Verfahren zur Bestimmung der Ausgangskapazität einer Spannungsversorgungsvorrichtung (12),

    bei dem eine Ausgangsspannung ($U_{12}$) in Höhe eines vorgegebenen ersten Messspannungswerts erzeugt wird,
    und danach die Spannungsversorgung abgeschaltet wird oder auf einen niedrigeren zweiten Messspannungswert heruntergeschaltet wird,
    so dass sich die Ausgangskapazität ($C_{d1}$, $C_{d2}$) über mindestens einen in der Spannungsversorgungsvorrichtung vorgesehenen Messwiderstand (34, 36, 38, 40) entlädt, wobei aus der Entladekurve der Kapazitätswert der Ausgangskapazität ($C_{d1}$, $C_{d2}$) ermittelt wird.

2.  Verfahren nach Anspruch 1,

    bei dem die Kapazitätsbestimmung automatisch durchgeführt wird,
    wobei eine Steuervorrichtung die Spannungsversorgungsvorrichtung (12) entsprechend steuert,
    und eine Messvorrichtung so steuert, dass Messwerte der Entladekurve aufgenommen werden,
    und aus den aufgenommenen Messwerten den Kapazitätswert ($D_{d1}$, $C_{d2}$) bestimmt.

3.  Verfahren nach Anspruch 1 oder 2,

    bei dem aus der Entladekurve der Kapazitätswert der Ausgangskapazität ($C_{d1}$, $C_{d2}$) ermittelt wird,
    indem die Zeitdifferenz ($\delta$) zwischen dem Erreichen oder Unterschreiten eines vorgegebenen Startspannungswerts ($U_A$) und dem Erreichen oder Unterschreiten eines vorgegebenen Endspannungswerts ($U_B$) gemessen wird,
    und der Kapazitätswert berechnet wird aus der Zeitdifferenz ($\delta$), dem Startspannungswert ($U_A$), dem Endspannungswert ($U_B$) und dem Widerstandswert des Messwiderstands oder der Messwiderstände (34, 36, 38, 40).

4.  Verfahren nach Anspruch 1 oder 2,

    bei dem aus der Entladekurve der Kapazitätswert der Ausgangskapazität ($C_d1$, $C_d2$) ermittelt wird,
    indem zu mindestens zwei festgelegten Zeitpunkten jeweils die Ausgangsspannung gemessen wird
    und die Spannungsdifferenz ermittelt wird
    und der Kapazitätswert berechnet wird aus der Spannungsdifferenz, den mindestens zwei Messpunkten und dem Widerstandswert des Messwiderstands oder der Messwiderstände (34, 36, 38, 40).

5.  Verfahren nach einem der vorangehenden Ansprüche,
    bei dem die Messung erst nach Ablauf einer vorbestimmten Wartezeit ($t_{delay}$) nach Abschalten der Spannungsversorgung beginnt.

**6.** Verfahren nach einem der vorangehenden Ansprüche,
bei dem die Bestimmung stattfindet, während eine Anschlussvorrichtung, insbesondere Stecker und/oder Kabel für den Anschluss einer Last an die Spannungsversorgungsvorrichtung (12) angekoppelt sind.

**7.** Verfahren nach einem der vorangehenden Ansprüche,
bei dem die Messwiderstände, über die sich die Spannung entlädt, mindestens einen Spannungsteiler (30, 32) aus mindestens zwei Widerständen (34, 36; 38, 40) bilden, und die heruntergeteilte Spannung ($U_1'$, $U_2'$), über mindestens einen der Widerstände (36, 38) des Spannungsteilers (30, 32) gemessen wird.

**8.** Verfahren nach einem der Ansprüche 1 bis 7 zur Bestimmung der ausgangsseitigen Kapazität einer Hochspannungsversorgungsvorrichtung für eine Röntgenröhre (10), bei dem die Röntgenröhre (10) während der Messung an die Hochspannungsversorgung (12) angeschlossen ist,
wobei aber kein Strom durch die Röhre (10) fließt.

**9.** Spannungsversorgungsvorrichtung mit

einer Spannungsversorgungseinheit, insbesondere einer Hochspannungsversorgungseinheit (12), mit mindestens zwei Ausgangsanschlüssen (22, 24)
und mindestens einem Messwiderstand (34, 36, 38,40), der zwischen die Ausgangsanschlüsse (22, 24) geschaltet ist,

**gekennzeichnet durch**

eine Vorrichtung zur automatischen Bestimmung der Ausgangskapazität,
wobei die Vorrichtung eine Spannungsmessvorrichtung für die Spannung ($U_{12}$) zwischen den Ausgangsanschlüssen (22, 24) aufweist,
und Mittel zur Ansteuerung der Spannungsversorgungseinheit, so dass eine Spannung ($U_{12}$) zwischen den Ausgangsanschlüssen (22, 24) erzeugt wird und die Spannungsversorgungseinheit danach abgeschaltet oder auf einen niedrigeren Spannungswert heruntergeschaltet wird,
sowie Mitteln zur Bestimmung der Ausgangskapazität aus der Messung der Spannung ($U_{12}$) zwischen den Ausgangsanschlüssen zu mindestens zwei Zeitpunkten ($t_A$, $t_B$) während der Entladung über den Messwiderstand (34, 36, 38, 40).

**10.** Spannungsversorgungsvorrichtung nach Anspruch 9,

bei der die Spannungsversorgungseinheit ein lastresonanter Umrichter (12), insbesondere mit Gleichspannungsausgang ist,
bei dem die Ausgangskapazität die Resonanzfrequenz mitbestimmt.

**11.** Spannungsversorgungsvorrichtung nach Anspruch 9 oder 10,
bei der mindestens eine Anschlussvorrichtung, insbesondere Kabel und/oder Stecker zum Anschluss einer Last vorgesehen ist.

**12.** Röntgengerät mit einer Spannungsversorgungsvorrichtung nach einem der Ansprüche 9 bis 11.

**13.** Röntgengerät nach Anspruch 12,
bei der mehrere Röntgenröhren (10) durch Kabel mit der Spannungsversorgungsvorrichtung (12) verbunden sind.

FIG. 1

8

FIG. 2

EP 1 202 068 A2